# EUROPEAN PATENT APPLICATION

(11) **EP 4 800 404 A1**
(43) Date of publication of application: **02.09.2026**
(21) Application number: 25816895.4
(22) Date of filing: 18.09.2025
(51) Int. Cl.: G01R 27/02, G01R 31/36, G01R 31/385

(54) **INSULATION IMPEDANCE DETECTION CIRCUIT AND DEVICE FOR BATTERY MODULE**

(30) Priority: 25.12.2024 CN 202411924272
(71) Applicant: Kehua Data Co., Ltd, 361000 Xiamen Fujian (CN); ZHANGZHOU KEHUA ELECTRIC TECHNOLOGY CO., LTD., Zhangzhou Fujian 363000 (CN)
(72) Inventor: ZHANG, Tinggang., Fujian 361000 (CN); ZENG, Wenxiong., Fujian 361000 (CN); HUANG, Muxin., Fujian 361000 (CN); LIN, Lvpeng., Fujian 361000 (CN)
(74) Representative: Regimbeau
(86) International application number: PCT/CN2025/122160
(87) International publication number: WO 2026/138016

(57) **Abstract**

Embodiments of the present application disclose an insulation resistance detection circuit and an insulation resistance detection device for a battery module. The insulation resistance detection circuit includes a detection port, an insulation resistance under measurement from the detection port to ground and a processor. The detection port of the insulation resistance detection circuit is connected to a positive terminal of a battery cell in the battery module. The processor is connected to a first switch, a second switch, and a voltage sampling unit, respectively, and is configured to: when controlling the first switch and the second switch to be closed or opened, determine a resistance value of the insulation resistance under measurement and a voltage value of the detection port based on a voltage sampled by the voltage sampling unit; and when determining that insulation resistance of the battery cell is abnormal based on the resistance value of the insulation resistance under measurement, determine a cell number of the battery cell in the battery module based on the voltage value of the detection port.

## Description

### CROSS-REFERENCE TO RELATED APPLICATION

This application is proposed based upon and claims priority to Chinese patent application No. 2024119242720 filed on December 25, 2024, the entire disclosure of which is hereby incorporated by reference in its entirety.

### TECHNICAL FIELD

The present disclosure relates to the technical filed of insulation resistance detection, in particular, to an insulation resistance detection circuit and an insulation resistance detection device for a battery module.

### BACKGROUND

A battery cell refers to a most basic component of a battery, generally, the battery cell is an electrochemical device encapsulated in a metal shell. The battery cell is a unit that stores and releases electrical energy, which converts chemical energy into the electrical energy through chemical reactions. The battery cell typically includes a positive electrode, a negative electrode, a separator and an electrolyte. Common types of battery cells include lithium batteries, nickel-metal hydride batteries, lead-acid batteries, etc. When the battery cells are used in the lithium batteries, the nickel-metal hydride batteries, the lead-acid batteries, or the like, a plurality of battery cells are typically connected in series to form a battery module, to provide a higher voltage and capacity by the battery module.

It is necessary to perform insulation resistance detection on the battery module, in order to determine whether the battery module is operating normally. In the existing insulation resistance detection for the battery module, generally, the insulation resistance of the entire battery module may be detected, to determine whether the insulation resistance of the battery module is abnormal. However, since there are many battery cells in the battery module, it is difficult to identify which battery cell, in the battery module, has an abnormal insulation resistance when detecting the insulation resistance of the entire battery module.

### SUMMARY

Embodiments of the present disclosure provide an insulation resistance detection circuit and an insulation resistance detection device for a battery module, which can accurately identify the battery cell having abnormal insulation resistance in the battery module.

There is provided an insulation resistance detection circuit for a battery module in an embodiment of the present disclosure. The battery module includes a plurality of battery cells connected in series, and the insulation resistance detection circuit includes: a detection port, an insulation resistance under measurement from the detection port to ground, a first switch, a second switch, a first resistor, a second resistor, a third resistor, a fourth resistor, a voltage sampling unit, and a processor.

One terminal of the first resistor and one terminal of the second resistor are connected to a positive terminal of the battery module, and the other terminal of the first resistor is connected to a node between the insulation resistance under measurement and the ground via the first switch.

The other terminal of the second resistor is connected to one terminal of the fourth resistor via the node, the other terminal of the fourth resistor is connected to a negative terminal of the battery module, and a sampling terminal of the voltage sampling unit is connected to both terminals of the fourth resistor or both terminals of the second resistor.

One terminal of the third resistor is connected to the node via the second switch, and the other terminal of the third resistor is connected to the negative terminal of the battery module.

The detection port of the insulation resistance detection circuit is connected to a positive terminal of a battery cell in the battery module.

The processor is connected to the first switch, the second switch, and the voltage sampling unit, respectively, and is configured to: when controlling the first switch and the second switch to be closed or opened, determine a resistance value of the insulation resistance under measurement and a voltage value of the detection port based on a voltage sampled by the voltage sampling unit; in response to determining that insulation resistance of the battery cell is abnormal based on the resistance value of the insulation resistance under measurement, determine a cell number of the battery cell in the battery module based on the voltage value of the detection port.

In some embodiments, the insulation resistance detection circuit further includes a third switch.

A connection point which connects the other terminal of the second resistor and the one terminal of the fourth resistor is connected to the node via the third switch.

The processor is connected to the third switch, and is further configured to: control the third switch to be closed when controlling the first switch and the second switch to be closed or opened, and control the third switch to be opened after the voltage is sampled by the voltage sampling unit.

In some embodiments, the detection port of the insulation resistance detection circuit is detachably connected to a positive terminal of each battery cell in the battery module, cell by cell.

The processor is further configured to determine, cell by cell, whether the insulation resistance of each battery cell is abnormal.

In some embodiments, the processor is further configured to control the first switch to be closed and control the second switch to be opened, and obtain a first voltage sampled by the voltage sampling unit.

The processor is further configured to control the first switch to be opened and control the second switch to be closed, and obtain a second voltage sampled by the voltage sampling unit.

The processor is further configured to determine, based on the first voltage and the second voltage, the resistance value of the insulation resistance under measurement and the voltage value of the detection port.

In some embodiments, the processor is further configured to control the first switch to be opened and control the second switch to be opened, and obtain a third voltage sampled by the voltage sampling unit.

The processor is further configured to control one of the first switch and the second switch to be closed and the other one of the first switch and the second switch to be opened, and obtain a fourth voltage sampled by the voltage sampling unit.

The processor is further configured to determine, based on the third voltage and the fourth voltage, the resistance value of the insulation resistance under measurement and the voltage value of the detection port.

In some embodiments, the first switch includes a first relay, and the second switch includes a second relay.

The other terminal of the first resistor is connected to the node between the insulation resistance under measurement and the ground via of a normally open contact of the first relay.

The one terminal of the third resistor is connected to the node via a normally open contact of the second relay.

The processor is connected to a coil of the first relay and a coil of the second relay.

In some embodiments, the processor is further configured to determine that the insulation resistance of the battery cell is abnormal if the resistance value of the insulation resistance under measurement is less than a preset resistance threshold.

The processor is further configured to determine that the insulation resistance of the battery cell is normal if the resistance value of the insulation resistance under measurement is greater than or equal to the preset resistance threshold.

In some embodiments, the processor is further configured to: obtain a voltage value of a single battery cell in the battery module, divide the voltage value of the detection port by the voltage value of the single battery cell to obtain a target quotient value, and determine the cell number of the battery cell in the battery module based on the target quotient value.

In some embodiments, the voltage sampling unit includes: a resistance matching module, an operational amplifier, and a voltage dividing and filtering module.

An input terminal of the resistance matching module is connected to both terminals of the fourth resistor or both terminals of the second resistor, an output terminal of the resistance matching module is connected to a non-inverting input terminal and an inverting input terminal of the operational amplifier, respectively, and the resistance matching module is configured to perform resistance matching on a differential voltage signal across a resistor, and input the resulting differential voltage signal into the operational amplifier.

An output terminal of the operational amplifier is connected to an input terminal of the voltage dividing and filtering module, and the operational amplifier is configured to follow the differential voltage signal and output a corresponding single-ended voltage signal.

The voltage dividing and filtering module is configured to perform voltage dividing and filtering on the single-ended voltage signal, and output the sampled voltage.

There is also provided an insulation resistance detection device for a battery module, which is configured to apply the above-mentioned insulation resistance detection circuit to perform insulation resistance detection for the battery module.

### BRIEF DESCRIPTION OF THE DRAWINGS

FIG. 1 is a diagram of an insulation resistance detection circuit for a battery module disclosed in an embodiment of the present disclosure.
FIG. 2 is a diagram of another insulation resistance detection circuit for a battery module disclosed in an embodiment of the present disclosure.

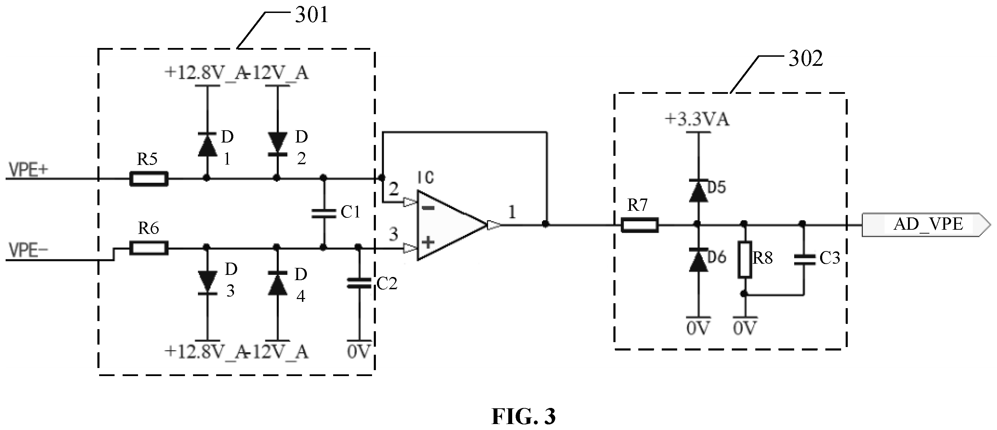

FIG. 3 is a diagram of a circuit of a voltage sampling unit disclosed in an embodiment of the present disclosure.

### DETAILED DESCRIPTION

To enable those skilled in the art to better understand the solution of the present disclosure, the technical solution of the present disclosure will be described clearly and completely with reference to the accompanying drawings in the embodiments of the present disclosure. It is apparent that the embodiments described herein are some of the embodiments of the present disclosure rather than all embodiments of present disclosure. All other embodiments obtained by those of ordinary skill in the art based on the embodiments of the present disclosure without paying inventive efforts shall fall within the scope of protection of the present disclosure.

In the description of the embodiments of the present disclosure, it should be noted that orientations or positional relationships indicated by the terms such as "center", "up", "down", "left", "right", "vertical", "horizontal", "inside", "outside" are orientations or positional relationships as illustrated in the drawings, and are only simplified description for convenience of description of the embodiments of the present disclosure, and do not indicate or imply that the referred devices or elements must have a specific orientation or be constructed and operated in a specific orientation, and therefore cannot be understood as a limitation of the embodiments of the present disclosure.

In the description of the embodiments of the present disclosure, it is noted that, unless otherwise expressly specified and limited, the terms such as "install", "communicate", and "connect" should be understood broadly, for example, which may be understood as connected in a fixed way, a detachable way, or an integral way; or may be mechanically connected or electrically connected; or may be directly connected or indirectly connected through an intermediate medium, or may be two elements internally communicated. For those of ordinary skill in the art, the specific meanings of the above terms in the embodiments of the present disclosure may be understood according to specific situations.

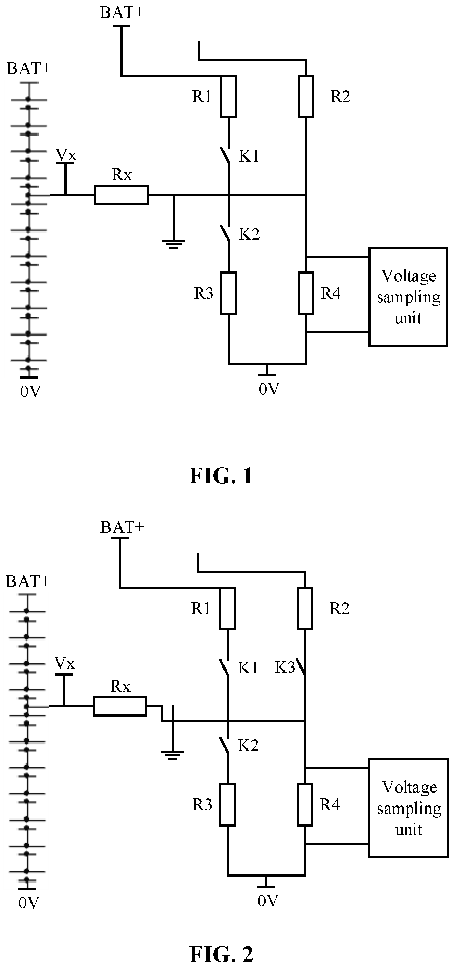

In the related art, when the insulation resistance detection is performed for the battery module, generally, the insulation resistance of the entire battery module is detected, i.e., the insulation resistance, from a positive terminal of the battery module to the ground, of the battery module is detected, to determine whether the insulation resistance of the battery module is abnormal. However, since there are many battery cells in the battery module, it is difficult to identify which battery cell, in the battery module, has abnormal insulation resistance when detecting the insulation resistance of the entire battery module. Therefore, the embodiments of the present disclosure provide an insulation resistance detection circuit for a battery module, which can accurately identify the battery cell having the abnormal insulation resistance in the battery module. The insulation resistance detection circuit is illustrated in FIG. 1.

In an embodiment of the present disclosure, a battery module (which may be referred to as a battery pole) includes a plurality of battery cells connected in series. In FIG. 1, BAT+ represents a positive terminal of the battery module, and 0V represents a negative terminal (i.e., the reference ground) of the battery module. The battery module may include a plurality of 3.3 V battery cells connected in series, such as 18 battery cells or 16 battery cells, which is not limited herein.

The insulation resistance detection circuit includes: a detection port, an insulation resistance Rx under measurement from the detection port to the ground, a first switch K1, a second switch K2, a first resistor R1, a second resistor R2, a third resistor R3, a fourth resistor R4, a voltage sampling unit, and a processor (not shown in FIG. 1). One terminal of the first resistor R1 and one terminal of the second resistor R2 are connected to the positive terminal BAT+ of the battery module, and the other terminal of the first resistor R1 is connected to a node between the insulation resistance Rx under measurement and the ground terminal via the first switch K1. The first resistor R1 is connected to the node when the first switch K1 is closed. The ground terminal may be a signal ground, a chassis ground, a protective ground, or the like, which is not specifically limited herein.

The other terminal of the second resistor R2 is connected to one terminal of the fourth resistor R4 via the node, and the other terminal of the fourth resistor R4 is connected to the negative terminal 0V of the battery module. The sampling terminal of the voltage sampling unit is connected to both terminals of the fourth resistor R4 or both terminals of the second resistor R2. It is understood that, when the sampling terminal of the voltage sampling unit is connected to both terminals of the fourth resistor R4, the voltage sampling unit samples a voltage across the fourth resistor R4; when the sampling terminal of the voltage sampling unit is connected to both terminals of the second resistor R2, the voltage sampling unit samples the voltage across the second resistor R2. In an embodiment of the present disclosure, the insulation resistance detection circuit will be described by taking the voltage sampling unit sampling the voltage across the fourth resistor R4 as an example. In the insulation resistance detection circuit, the voltage sampling unit may also sample the voltage across the second resistor R2, which will not be elaborated in detail below.

One terminal of the third resistor R3 is connected to the node via the second switch K2, and the other terminal of the third resistor R3 is connected to the negative terminal 0V of the battery module. The detection port of the insulation resistance detection circuit is connected to the positive terminal of any battery cell in the battery module. It is understood that the insulation resistance Rx under measurement from the detection port to the ground denotes the insulation resistance from the battery cell to the ground detected by the insulation resistance detection circuit, and the voltage Vx of the detection port denotes the voltage-to-ground detected for the battery cell.

The processor is connected to the first switch K1, the second switch K2, and the voltage sampling unit, respectively, and is configured to determine, based on the voltage sampled by the voltage sampling unit, a resistance value of the resistance Rx under measurement and a voltage value of the voltage Vx at the detection port when controlling the first switch K1 and the second switch K2 to be closed or opened. In some embodiments, on the basis of the principle that a nodal current of the node is 0A, i.e., an input current equals an output current at the node, by controlling the first switch K1 and the second switch K2 to be closed or opened, and utilizing the voltage sampled by the voltage sampling unit, multiple nodal current equations including the resistance values of the insulation resistance under measurement and the voltage values at the detection port may be established. Therefore, the resistance value of the insulation resistance under measurement and the voltage value at the detection port are obtained. The processor may be a microcontroller (MCU) or a digital signal processor (DSP), which is not specifically limited herein.

The processor, after obtaining the resistance value of the insulation resistance under measurement and the voltage value of the detection port, may determine whether insulation resistance of the battery cell is abnormal based on the resistance value of the insulation resistance under measurement. In some embodiments, to ensure that the battery cell is effectively insulated from the ground, the insulation resistance of the battery cell shall be greater than a preset resistance threshold. The preset resistance threshold may be, for example, 10 Ω or 20 Ω, which is not specifically limited herein. If the resistance value of the insulation resistance under measurement is less than to the preset resistance threshold, the insulation resistance of the battery cell is determined to be abnormal. If the resistance value of the insulation resistance under measurement is greater than or equal to the preset resistance threshold, the insulation resistance of the battery cell is determined to be normal.

When the insulation resistance of the battery cell is determined to be abnormal based on the resistance value of the insulation resistance under measurement, the cell number of the battery cell in the battery module is determined based on the voltage value of the detection port. That is, when the battery cell is determined as a battery cell having the abnormal insulation resistance, a location of the battery with abnormal insulation resistance in the battery module may be determined. In some embodiments, the processor may obtain the voltage value of a single battery cell in the battery module, and it is understood that, the voltage value of each battery cell in the battery module is the same, and the voltage value of a single battery cell may be 3.3 V or 4.5 V, which is not specifically limited herein. The voltage value of the detection port is divided by the voltage value of the single battery cell to obtain a target quotient value, and the cell number of the battery cell in the battery module is determined based on the target quotient value. The cell number corresponding to the battery cell with abnormal insulation resistance in the battery module is given by the ceiling of the quotient of the detected voltage value of the detection port divided by the voltage value of the single battery cell. For example, if the voltage value of the single battery cell is 3.3 V and the voltage value of the detection port is 6.5 V, the resulting target quotient value is approximately 1.97, then the cell number of the battery cell in the battery module is identified the second cell, which indicates that the detection port is connected to the positive terminal of the second cell (or, equivalently, the negative electrode of the third cell).

Thus, in the embodiments of the present disclosure, the detection port of the insulation resistance detection circuit is connected to the positive terminal of any battery cell in the battery module, and when the processor controls the first switch and the second switch to be closed or opened, the processor determines, based on the voltage sampled by the voltage sampling unit, the resistance value of the insulation resistance under measurement and the voltage value of the detection port as the resistance value of the insulation resistance of the battery cell and the voltage value corresponding to the battery cell in the battery module, respectively. The processor, when determining that the insulation resistance of the battery cell is abnormal, determines the cell number of the battery cell in the battery module based on the voltage value of the detection port, thereby enabling the precise identification of the battery cell with abnormal insulation resistance in the battery module.

As illustrated in FIG. 2, in an embodiment of the present disclosure, the insulation resistance detection circuit further includes a third switch K3. One terminal of the second resistor R2 is connected to the positive terminal BAT+ of the battery module, and the other terminal of the second resistor R2 is connected in series with one terminal of the fourth resistor R4. The connection point between the other terminal of the second resistor R2 and the one terminal of the fourth resistor R4 is connected to the node via the third switch K3. The processor is connected to the third switch K3, and is further configured to control the third switch K3 to be closed when controlling the first switch K1 and the second switch K2 to be closed or opened, and control the third switch K3 to be opened after the voltage is sampled by the voltage sampling unit. That is, the processor, in the process of performing the detection by the insulation resistance detection circuit, controls the third switch K3 to be closed, to connect the second resistor R2 and the fourth resistor R4 to the node between the insulation resistance under measurement and the ground terminal, so as to associate the voltage sampled by the voltage sampling unit with the resistance value of the insulation resistance under measurement and the voltage value of the detection port, to obtain the corresponding nodal current equation. After the detection is completed, the processor controls the third switch K3 to be opened, which can effectively prevent the current, which flows from the second resistor R2, from back-feeding through the node and the detection port into the battery module, thereby enhancing the safety of the battery module.

In an embodiment of the present disclosure, the detection port of the insulation resistance detection circuit is detachably connected to a positive terminal of each battery cell in the battery module, cell by cell. For example, the detection port may be connected to the battery module, from the positive terminal of the first battery cell to the positive terminal of the last battery cell in sequence. The processor is further configured to: determine the resistance value of the insulation resistance under measurement corresponding to a battery cell when the detection port is connected to the positive terminal of the battery cell, and determine whether the insulation resistance of the battery cell is abnormal cell by cell based on the resistance value of the insulation resistance under measurement, which enables a comprehensive insulation resistance detection for each battery cell within the battery module, thereby improving the accuracy for the insulation resistance detection for the battery module.

In some embodiments, the principle of the detection function of the insulation resistance detection circuit includes that: the processor is configured to control the first switch K1 to be closed and the second switch K2 to be opened, and obtain the first voltage V1 (i.e., the voltage across the fourth resistor R4) sampled by the voltage sampling unit, then, based on the principle that the nodal current is 0, the obtained nodal current equation is:
$\frac{{V}_{BAT} - V 1}{\frac{R 1 ∗ R 2}{R 1 + R 2}} + \frac{Vx - V 1}{Rx} = \frac{V 1}{R 4}$ where *V_{BAT}* is the voltage of the battery module, *Vx* is the voltage of the detection port, and *Rx* is the insulation resistance under measurement.

The processor is further configured to control the first switch K1 to be opened and the second switch K2 to be closed, and obtain the second voltage V2 sampled by the voltage sampling unit, then, based on the principle that the nodal current is 0, the obtained nodal current equation is: $\frac{{V}_{BAT} - V 2}{R 2} + \frac{Vx - V 2}{Rx} = \frac{V 2}{\frac{R 3 ∗ R 4}{R 3 + R 4}}$
the processor is further configured to determine, based on the first voltage and the second voltage, the resistance value of the insulation resistance under measurement and the voltage value of the detection port.

That is, based on Equation 1 and Equation 2, the following equations can be derived: $Vx = \frac{\left(R1+R2\right) R 3 R 4 {V}_{BAT} V 2 - R 1 R 3 R 4 {V}_{BAT} V 1 + \left(R1-R3\right) R 2 R 4 V 1 V 2}{R 2 R 3 R 4 {V}_{BAT} - \left(R1R2+R1R4+R2R4\right) R 3 V 1 + \left(R2R3+R2R4+R3R4\right) R 1 V 2}$ $Rx = \frac{R 1 R 2 R 3 R 4 \left(V1-V2\right)}{R 2 R 3 R 4 {V}_{BAT} - \left(R1R2+R1R4+R2R4\right) R 3 V 1 + \left(R2R3+R2R4+R3R4\right) R 1 V 2}$

In an embodiment of the present disclosure, the detection principle of the insulation resistance detection circuit may alternatively include that: the processor is configured to control the first switch K1 to be opened and the second switch K2 to be opened, and obtain the third voltage V3 sampled by the voltage sampling unit, then, the obtained nodal current equation is: $\frac{{V}_{BAT} - V 3}{R 2} + \frac{Vx - V 3}{Rx} = \frac{V 3}{R 4}$

The processor is further configured to: control one of the first switch K1 and the second switch K2 to be closed and the other switch to be opened, and acquire the fourth voltage V4 sampled by the voltage sampling unit. When the first switch K1 is controlled to be closed and the second switch K2 is controlled to be opened, the obtained nodal current equation is the above-mentioned Equation 1; and when the first switch K1 is controlled to be opened and the second switch K2 is controlled to be closed, the obtained nodal current equation is the above-mentioned Equation 2. Then the resistance value of the insulation resistance under measurement and the voltage value of the detection port are determined based on the third voltage and the fourth voltage.

It can be understood that the first switch K1 and the second switch K2 may be controlled to be closed and opened through multiple control schemes, and then the resistance value of the insulation resistance under measurement and the voltage value of the detection port can be obtained based on the voltage sampled by the voltage sampling unit.

In some embodiments, the first switch K1 includes a first relay, and the second switch K2 includes a second relay. The other terminal of the first resistor R1 is connected to the node between the insulation resistance under measurement and the ground via a normally open contact of the first relay; and the one terminal of the third resistor R3 is connected to the node via a normally open contact of the second relay. The processor is connected to a coil of the first relay and a coil of the second relay. When the processor does not enable the power supply to the relay coil, the normally open contact of the relay remains open; and when the processor enables the power supply to the relay coil, the normally open contact of the relay is closed, thereby realizing the switching function of the relay.

In an embodiment of the present disclosure, the voltage sampling unit includes a resistance matching module 301, an operational amplifier integrated circuit (IC), and a voltage dividing and filtering module 302. VPE+ represents the voltage at the positive terminal of the resistor, VPE- represents the voltage at the negative terminal of the resistor, and VPE+ and VPE- constitute a differential voltage signal. The input terminal of the resistance matching module 301 is the sampling terminal of the voltage sampling unit, the input terminal of the resistance matching module 301 is connected to both terminals of the fourth resistor or both terminals of the second resistor, and the output terminal of the resistance matching module 301 is respectively connected to the non-inverting input terminal and the inverting input terminal of the operational amplifier IC. The resistance matching module 301 includes a resistor R5, a resistor R6, a diode D1, a diode D2, a diode D3, a diode D4, and a capacitor C1 and a capacitor C2. The resistance matching module 301 is configured to perform resistance matching on the differential voltage signal across a resistor and input the resulting differential voltage signal into the operational amplifier. The output terminal of the operational amplifier IC is connected to the input terminal of the voltage dividing and filtering module 302, and the operational amplifier IC is configured to follow the resulting differential voltage signal and output a corresponding single-ended voltage signal. The voltage dividing and filtering module 302 includes a resistor R7, a resistor R8, a diode D5 and a diode D6, and a capacitor C3. The voltage dividing and filtering module 302 is configured to perform voltage dividing and filtering on the single-ended voltage signal and output the sampled voltage AD_VPE (i.e., the analog-to-digital (AD) sampling voltage).

In an implementable embodiment, verification may be performed on the insulation resistance detection circuit in the process of detecting the resistance value of the insulation resistance under measurement and the voltage value of the detection port by the insulation resistance detection circuit. In some embodiments, the resistance having different resistance values may be connected in series between the positive terminal and the ground terminal of different battery cells, to detect the actual voltage of the battery cell and the actual insulation resistance, and the insulation resistance under measurement and the voltage of the detection port detected by the processor. The detection range of the insulation resistance is generally 0 to 198 kΩ, and the resistance having different resistance values may include resistors with the following values: 0.000 kΩ, 0.010 kΩ, 0.0468 kΩ, 0.910 kΩ, 20.45 kΩ, 49.50 kΩ or 198 kΩ. If a 0.000 kΩ resistor is connected in series between the positive terminal of different battery cells and the ground terminal, the following corresponding data may be obtained:

| Series Connection Location | Displayed | Theoretical | Displayed | Theoretical | Rx deviation (kΩ) | Rx sampling accuracy | Vx Deviation (V) | Vx sampling accuracy |
|---|---|---|---|---|---|---|---|---|
| | Rx (kΩ) | Rx (kΩ) | Vx (V) | Vx (V) | | | | |
| Cell 1 Negative | 0.0009 | 0.000 | 0.0000 | 0.0000 | 0.0009 | / | 0.0000 | / |
| Cell 2 Negative | 0.0035 | 0.0000 | 3.2759 | 3.3260 | 0.0035 | / | -0.0501 | 98.49% |
| Cell 3 Negative | 0.0015 | 0.0000 | 6.5770 | 6.6400 | 0.0015 | / | -0.0630 | 99.05% |
| Cell 4 Negative | 0.0045 | 0.0000 | 9.8712 | 9.9800 | 0.0045 | / | -0.1088 | 98.91% |
| Cell 5 Negative | 0.0039 | 0.0000 | 13.1724 | 13.2800 | 0.0039 | / | -0.1076 | 99.19% |
| Cell 6 Negative | 0.0041 | 0.0000 | 16.4694 | 16.6300 | 0.0041 | / | -0.1606 | 99.03% |
| Cell 7 Negative | 0.0024 | 0.0000 | 19.7641 | 19.9200 | 0.0024 | / | -0.1559 | 99.22% |
| Cell 8 Negative | 0.0044 | 0.0000 | 23.0596 | 23.2800 | 0.0044 | / | -0.2204 | 99.05% |
| Cell 9 Negative | 0.0002 | 0.0000 | 26.3584 | 26.6100 | 0.0002 | / | -0.2516 | 99.05% |
| Cell 10 Negative | 0.0027 | 0.0000 | 29.6462 | 29.9400 | 0.0027 | / | -0.2938 | 99.02% |
| Cell 11 Negative | 0.0047 | 0.0000 | 32.9491 | 33.2600 | 0.0047 | / | -0.3109 | 99.07% |
| Cell 12 Negative | 0.0051 | 0.0000 | 36.2355 | 36.5900 | 0.0051 | / | -0.3545 | 99.03% |
| Cell 13 Negative | 0.0027 | 0.0000 | 39.5331 | 39.9200 | 0.0027 | / | -0.3869 | 99.03% |
| Cell 14 Negative | 0.0093 | 0.0000 | 42.8347 | 43.2400 | 0.0093 | / | -0.4053 | 99.06% |
| Cell 15 Negative | 0.0007 | 0.0000 | 46.1237 | 46.5700 | 0.0070 | / | -0.4463 | 99.04% |
| Cell 16 Negative | 0.0019 | 0.0000 | 49.4146 | 49.9000 | 0.0019 | / | -0.4854 | 99.03% |
| Cell 17 Negative | 0.0013 | 0.0000 | 52.6989 | 53.2200 | 0.0013 | / | -0.5211 | 99.02% |
| Cell 18 Negative | 0.0012 | 0.0000 | 55.9952 | 56.5500 | 0.0012 | / | -0.5548 | 99.02% |
| Cell 18 Positive | 0.0009 | 0.0000 | 59.3398 | 59.7600 | 0.0090 | / | -0.4202 | 99.30% |

The theoretical Rx represents the actual resistance connected in series from the positive terminal of different battery cells and the ground terminal; the theoretical Vx represents the actual voltage at the battery cell; the displayed Rx represents the insulation resistance detected by the insulation resistance detection circuit; and the displayed Vx represents the voltage of the detection port detected by the insulation resistance detection circuit. The sampling accuracy is calculated by dividing the displayed value by its corresponding theoretical value. As evidenced, the sampling accuracy for the insulation resistance of 1 ~ 198 kΩ is greater than or equal to 96%; the sampling accuracy for the corresponding battery cell voltage is greater than or equal to 95%, and the sampling accuracy for both the insulation resistance and battery cell voltage meets the requirements.

Optionally, the maximum deviation between the displayed Rx and the theoretical Rx and the maximum value of the insulation resistance within the measurement range may be obtained, to obtain a sampling linearity of the insulation resistance calculated by the formula: 1 - (maximum deviation / maximum value). Therefore, the obtained sampling linearity for the insulation resistance is greater than or equal to 97%; correspondingly, the sampling linearity of the obtained battery cell voltage is greater than or equal to 97%, and the sampling linearity of both the insulation resistance and the battery cell voltage meets the requirements.

Given that the battery module may be deployed in high and low-temperature environments, for example, the operational temperature environment for the entire S³ lithium battery is 0 to 40 °C, in such situation, the insulation resistance detection circuit may be placed in the high and low-temperature environments for verification of the insulation resistance detection circuit. The manner for accessing the sampling accuracy and sampling linearity is similar to those described above, to demonstrate that the sampling accuracy for both the insulation resistance and the battery cell voltage in the high and low-temperature environments meets the requirements, and that the sampling linearity for both the insulation resistance and the battery cell voltage meets the requirements.

There is also provided an insulation resistance detection device for a battery module, which is configured to apply the above-mentioned insulation resistance detection circuit to perform insulation resistance detection for the battery module.

In the present disclosure, the terms such as "first", "second", "third", and "fourth" are used for descriptive purposes only and cannot be understood as indicating or implying relative importance. The term "a plurality of" refers to two or more, unless expressly limited otherwise.

The above embodiments are merely used for description of the technical solutions of the embodiments of the present disclosure, and are not limited thereto. Although the embodiments of the present disclosure have been described in detail with reference to the above-described embodiments, those skilled in the art will understand that modifications to the technical solutions described in the foregoing embodiments or equivalent substitutions for some or all of the technical features therein may be made. Such modifications or substitutions cannot cause the essence of the corresponding technical solutions to depart from the scope of the technical solutions of the embodiments of the present disclosure, and shall fall within the scope of the claims and the specification of the embodiments of the present disclosure.

### Industrial applicability

The detection port of the insulation resistance detection circuit is connected to the positive terminal of any battery cell in the battery module, and when controlling the first switch and the second switch to be closed or opened, the processor determines, based on the voltage sampled by the voltage sampling unit, the resistance value of the insulation resistance under measurement and the voltage value of the detection port as the resistance value of the insulation resistance of the battery cell and the voltage value corresponding to the battery cell in the battery module, respectively. The processor, when determining that the insulation resistance of the battery cell is abnormal, determines the cell number of the battery cell in the battery module based on the voltage value of the detection port, thereby enabling the precise identification of the battery cell with abnormal insulation resistance in the battery module.

## Claims

1. An insulation resistance detection circuit for a battery module, wherein the battery module comprises a plurality of battery cells connected in series, and the insulation resistance detection circuit comprises: a detection port, an insulation resistance under measurement from the detection port to ground, a first switch, a second switch, a first resistor, a second resistor, a third resistor, a fourth resistor, a voltage sampling unit, and a processor, wherein
one terminal of the first resistor and one terminal of the second resistor are connected to a positive terminal of the battery module, and the other terminal of the first resistor is connected to a node between the insulation resistance under measurement and the ground via the first switch;
the other terminal of the second resistor is connected to one terminal of the fourth resistor via the node, the other terminal of the fourth resistor is connected to a negative terminal of the battery module, and a sampling terminal of the voltage sampling unit is connected to both terminals of the fourth resistor or both terminals of the second resistor;
one terminal of the third resistor is connected to the node via the second switch, and the other terminal of the third resistor is connected to the negative terminal of the battery module;
the detection port of the insulation resistance detection circuit is connected to a positive terminal of a battery cell in the battery module; and
the processor is connected to the first switch, the second switch, and the voltage sampling unit, respectively, and is configured to: when controlling the first switch and the second switch to be closed or opened, determine a resistance value of the insulation resistance under measurement and a voltage value of the detection port based on a voltage sampled by the voltage sampling unit; in response to determining that insulation resistance of the battery cell is abnormal based on the resistance value of the insulation resistance under measurement, determine a cell number of the battery cell in the battery module based on the voltage value of the detection port.

2. The insulation resistance detection circuit of claim 1, further comprising a third switch, wherein
a connection point which connects the other terminal of the second resistor and the one terminal of the fourth resistor is connected to the node via the third switch; and
the processor is connected to the third switch, and is further configured to: control the third switch to be closed when controlling the first switch and the second switch to be closed or opened, and control the third switch to be opened after the voltage is sampled by the voltage sampling unit.

3. The insulation resistance detection circuit of claim 1 or 2, wherein the detection port of the insulation resistance detection circuit is detachably connected to a positive terminal of each battery cell in the battery module, cell by cell; and
the processor is further configured to determine, cell by cell, whether the insulation resistance of each battery cell is abnormal.

4. The insulation resistance detection circuit of any one of claims 1 to 3, wherein the processor is further configured to:
control the first switch to be closed and control the second switch to be opened, and obtain a first voltage sampled by the voltage sampling unit;
control the first switch to be opened and control the second switch to be closed, and obtain a second voltage sampled by the voltage sampling unit; and
determine, based on the first voltage and the second voltage, the resistance value of the insulation resistance under measurement and the voltage value of the detection port.

5. The insulation resistance detection circuit of any one of claims 1 to 4, wherein the processor is further configured to:
control the first switch to be opened and control the second switch to be opened, and obtain a third voltage sampled by the voltage sampling unit;
control one of the first switch and the second switch to be closed and the other one of the first switch and the second switch to be opened, and obtain a fourth voltage sampled by the voltage sampling unit; and
determine, based on the third voltage and the fourth voltage, the resistance value of the insulation resistance under measurement and the voltage value of the detection port.

6. The insulation resistance detection circuit of any one of claims 1 to 5, wherein the first switch comprises a first relay, and the second switch comprises a second relay, wherein
the other terminal of the first resistor is connected to the node between the insulation resistance under measurement and the ground via a normally open contact of the first relay;
the one terminal of the third resistor is connected to the node via a normally open contact of the second relay; and
the processor is connected to a coil of the first relay and a coil of the second relay.

7. The insulation resistance detection circuit of any one of claims 1 to 6, wherein the processor is further configured to determine that the insulation resistance of the battery cell is abnormal if the resistance value of the insulation resistance under measurement is less than a preset resistance threshold; and
determine that the insulation resistance of the battery cell is normal if the resistance value of the insulation resistance under measurement is greater than or equal to the preset resistance threshold.

8. The insulation resistance detection circuit of any one of claims 1 to 7, wherein the processor is further configured to: obtain a voltage value of a single battery cell in the battery module, divide the voltage value of the detection port by the voltage value of the single battery cell to obtain a target quotient value, and determine the cell number of the battery cell in the battery module based on the target quotient value.

9. The insulation resistance detection circuit of any one of claims 1 to 8, wherein the voltage sampling unit comprises: a resistance matching module, an operational amplifier, and a voltage dividing and filtering module, wherein
an input terminal of the resistance matching module is connected to both terminals of the fourth resistor or both terminals of the second resistor, an output terminal of the resistance matching module is connected to a non-inverting input terminal and an inverting input terminal of the operational amplifier, respectively, and the resistance matching module is configured to perform resistance matching on a differential voltage signal across a resistor, and input the resulting differential voltage signal into the operational amplifier; and
an output terminal of the operational amplifier is connected to an input terminal of the voltage dividing and filtering module, and the operational amplifier is configured to follow the resulting differential voltage signal and output a corresponding single-ended voltage signal; and
the voltage dividing and filtering module is configured to perform voltage dividing and filtering on the single-ended voltage signal, and output the sampled voltage.

10. An insulation resistance detection device for a battery module, configured to use the insulation resistance detection circuit of any one of claims 1 to 9 to perform insulation resistance detection for the battery module.
